# EUROPEAN PATENT APPLICATION

(11) **EP 4 832 051 A1**
(43) Date of publication of application: **28.10.2026**
(21) Application number: 24907475.8
(22) Date of filing: 19.12.2024
(51) Int. Cl.: H01L 21/304, H01L 21/027

(54) **CLEANING SOLUTION FOR SIMULTANEOUSLY REMOVING PHOTORESIST RESIDUE AND ETCH STOP LAYER, AND METHOD FOR MANUFACTURING SEMICONDUCTOR CIRCUIT ELEMENT USING SAME**

(30) Priority: 22.12.2023 US 202363613801 P
(71) Applicant: MITSUBISHI GAS CHEMICAL COMPANY, INC., Chiyoda-ku Tokyo 100-8324 (JP)
(72) Inventor: SHIMADA, Kenji, Tokyo 100-8324 (JP); TAKAKUWA, Hiroaki, Forest Grove, Oregon 971163099 (US); KIKUNAGA, Takahiro, Tokyo 125-8601 (JP)
(74) Representative: Müller-Boré & Partner Patentanwälte PartG mbB
(86) International application number: PCT/JP2024/044885
(87) International publication number: WO 2025/135091

(57) **Abstract**

According to the present invention, there can be provided a cleaning solution that simultaneously removes a photoresist film or a residue generated after the ashing treatment of photoresist, and aluminum oxide as an etching stopper layer, in a step of forming a metal wiring on a substrate, wherein the cleaning solution comprises at least one type of organic alkali selected from the group consisting of amines or quaternary ammonium hydroxide, and at least one type of organic solvent (excluding dimethyl sulfoxide), and the concentration of the amines is 0.1% by mass to 25% by mass with respect to the total mass of the cleaning solution, or the concentration of the quaternary ammonium hydroxide is 0.05% by mass to 0.5% by mass with respect to the total mass of the cleaning solution.

## Description

### Technical Field

The present invention relates to: a cleaning solution that simultaneously removes a photoresist film or a residue generated after the ashing treatment of photoresist, and aluminum oxide as a dry etching stopper layer, in a step of forming a metal wiring on a substrate; and a method for producing a semiconductor circuit element using the cleaning solution.

### Background Art

The step of producing a semiconductor substrate includes a dry etching step, and this dry etching step is a step of selectively removing specific materials over other materials. During the dry etching step, a remaining etching residue called dry etching residue, a metal scrap and the like remain on the surface after the etching treatment. Cleaning solution is used to remove these residues.

Semiconductor substrate may sometimes contain a dry etching stopper layer, such as aluminum oxide, to prevent damage to wiring materials caused by dry etching.

A cleaning technique of removing the dry etching residue and the dry etching stopper layer, while protecting corrosion of the substrate's wiring materials and interlayer dielectric films is required. Furthermore, it is necessary to suppress the side etching of the dry etching stopper layer, such as aluminum oxide, which is a phenomenon undesirable for a film formation step after cleaning.

Redox agents may be sometimes used in cleaning solutions to weaken the dry etching residue. However, the redox agents are problematic in that these agents provoke performance degradation due to decomposition of components in the cleaning solution, and changes in the material quality of a substrate surface, etc.

In addition, anticorrosive agents may be sometimes used to prevent damage to the wiring materials, but anticorrosive agents adsorbed on the surface of the wiring materials need to be removed, so that inconvenience does not occur in the film formation step after cleaning.

Under such circumstances, Patent Literature 1 describes a resist stripping composition comprising tetramethylammonium hydroxide, acetonitrile, dimethyl sulfoxide, and water. Dimethyl sulfoxide is the most frequently used solvent, but it is unsatisfactory in terms of its ability to remove a photoresist film or a residue generated after the ashing treatment of photoresist.

### Citation List

### Patent Literature

Patent Literature 1: JP Patent Publication No. 2008-3291 A

### Summary of Invention

### Technical Problem

It is an object of the present invention to provide: a cleaning solution that is capable of simultaneously performing the corrosion protection of metal wirings and interlayer dielectric films, and the removal of a photoresist film or a residue generated after the ashing treatment of photoresist, and an etching stopper layer, which have been difficult to cope with according to conventional methods; and a method for producing a semiconductor circuit element using this cleaning solution.

### Solution to Problem

The present inventors have conducted intensive studies directed towards achieving the above-described object, and as a result, the present inventors have found that the above-described object can be achieved by using a cleaning solution comprising at least one type of organic alkali selected from the group consisting of amines or quaternary ammonium hydroxide, and at least one type of organic solvent (excluding dimethyl sulfoxide), in specific amounts. Specifically, the present invention is as follows.
< 1 > A cleaning solution that simultaneously removes a photoresist film or a residue generated after the ashing treatment of photoresist, and aluminum oxide as an etching stopper layer, in a step of forming a metal wiring on a substrate,
   wherein the cleaning solution comprises at least one type of organic alkali selected from the group consisting of amines or quaternary ammonium hydroxide, and at least one type of organic solvent (excluding dimethyl sulfoxide), and
   the concentration of the amines is 0.1% by mass to 25% by mass with respect to the total mass of the cleaning solution, or the concentration of the quaternary ammonium hydroxide is 0.05% by mass to 0.5% by mass with respect to the total mass of the cleaning solution.
< 2 > The cleaning solution according to the above < 1 >, wherein the amines or the quaternary ammonium hydroxide is one or more types selected from the group consisting of 2-(methylamino)ethanol, 2-(ethylamino)ethanol, N,N-bis(3-aminopropyl)ethylenediamine, 3,3-diaminodipropylamine, ethylenediamine, diethylenetriamine, 4-amino-1-butanol, 6-amino-1-hexanol, tetramethylammonium hydroxide, tetraethylammonium hydroxide, tetrapropylammonium hydroxide, and tetrabutylammonium hydroxide.
< 3 > The cleaning solution according to the above < 1 > or < 2 >, wherein the organic solvent is one or more types selected from the group consisting of glycol ethers, acetonitrile, and acetone.
< 4 > The cleaning solution according to the above < 3 >, wherein the glycol ethers are one or more types selected from the group consisting of diethylene glycol monomethyl ether, diethylene glycol monobutyl ether, ethylene glycol monobutyl ether, and diethylene glycol monohexyl ether.
< 5 > The cleaning solution according to any one of the above < 1 > to < 4 >, wherein the concentration of the amines is 0.3% by mass to 10% by mass with respect to the total mass of the cleaning solution, or the concentration of the quaternary ammonium hydroxide is 0.1% by mass to 0.4% by mass with respect to the total mass of the cleaning solution.
< 6 > The cleaning solution according to any one of the above < 1 > to < 5 >, wherein the concentration of the organic solvent is 45% by mass to 85% by mass with respect to the total mass of the cleaning solution.
< 7 > The cleaning solution according to any one of the above < 1 > to < 6 >, wherein the pH of the cleaning solution is in the range of pH 8 to 13.
< 8 > A method for producing a semiconductor circuit element, comprising a step of removing a photoresist or a photoresist residue after ashing, using the cleaning solution according to any one of the above < 1> to < 7 >.

### Advantageous Effects of Invention

According to the present invention, there can be provided: a cleaning solution capable of simultaneously removing a photoresist film or a residue generated after the ashing treatment of photoresist, and aluminum oxide as an etching stopper layer, in a step of forming a metal wiring on a substrate; and a method for producing a semiconductor circuit element using this cleaning solution.

### Brief Description of Drawings]

[Figure 1] Figure 1 is a schematic view showing a state in which a photoresist film and aluminum oxide as an etching stopper layer are simultaneously removed using the cleaning solution of the present invention.
[Figure 2] Figure 2 is a schematic view showing a state in which a residue generated after the ashing treatment of photoresist and aluminum oxide as an etching stopper layer are simultaneously removed using the cleaning solution of the present invention.

### Description of Embodiments

The cleaning solution of the present invention is used to simultaneously remove a photoresist film or a residue generated after the ashing treatment of photoresist, and aluminum oxide as an etching stopper layer, in a step of forming a metal wiring on a substrate.

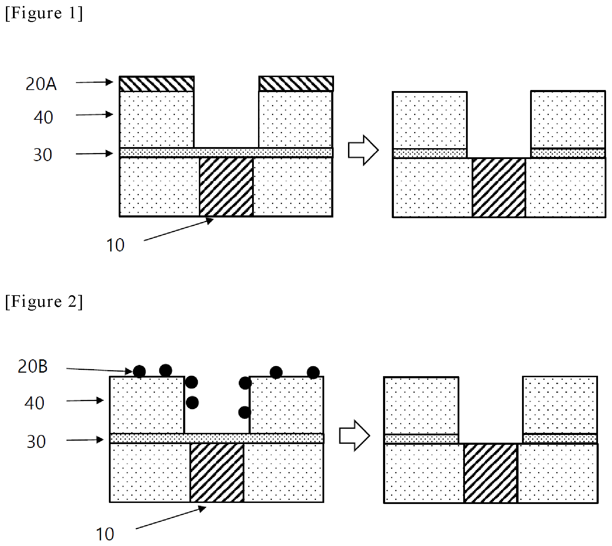

Figure 1 shows a state in which a photoresist film 20A and an exposed AlOx etching stopper layer 30 are simultaneously removed using the cleaning solution of the present invention.

Figure 2 shows a state in which a photoresist residue 20B after ashing and an exposed AlOx etching stopper layer 30 are simultaneously removed using the cleaning solution of the present invention.

On the other hand, the cleaning solution of the present invention, as shown in Figures 1 and 2, does not damage interlayer dielectric films 40, an AlOx etching stopper layer 30 sandwiched between the interlayer dielectric films 40, or a metal wiring 10.

The cleaning solution of the present invention comprises at least one type of organic alkali selected from the group consisting of amines or quaternary ammonium hydroxide, and at least one type of organic solvent (excluding dimethyl sulfoxide). Hereafter, the cleaning solution of the present invention will be described in detail.

### [Amines or quaternary ammonium hydroxide]

The amines or the quaternary ammonium hydroxide used in the present invention is not particularly limited, as long as it can be used to simultaneously remove a photoresist film or a residue generated after the ashing treatment of photoresist, and aluminum oxide as an etching stopper layer. The amines or the quaternary ammonium hydroxide is preferably one or more types selected from the group consisting of 2-(methylamino)ethanol, 2-(ethylamino)ethanol, N,N-bis(3-aminopropyl)ethylenediamine, 3,3-diaminodipropylamine, ethylenediamine, diethylenetriamine, 4-amino-1-butanol, 6-amino-1-hexanol, tetramethylammonium hydroxide, tetraethylammonium hydroxide, tetrapropylammonium hydroxide, and tetrabutylammonium hydroxide; the amines or the quaternary ammonium hydroxide is more preferably any one or more of 2-(methylamino)ethanol, 2-(ethylamino)ethanol, and tetramethylammonium hydroxide; and the amines or the quaternary ammonium hydroxide is particularly preferably 2-(methylamino)ethanol. These organic alkalis may be used alone as one type, or may also be used in combination of two or more types. These organic alkalis can be easily obtained as commercially available products, and can be preferably used.

The concentration of the amines is 0.1% by mass to 25% by mass, preferably 0.2% by mass to 20% by mass, and more preferably 0.3% by mass to 10% by mass, with respect to the total mass of the cleaning solution.

The concentration of the quaternary ammonium hydroxide is 0.05% by mass to 0.5% by mass, preferably 0.08% by mass to 0.45% by mass, and more preferably 0.1% by mass to 0.4% by mass, with respect to the total mass of the cleaning solution. By setting the aforementioned concentrations within such ranges, both the property of removing the photoresist film or the residue generated after the ashing treatment of photoresist, and the property of removing the etching stopper layer containing aluminum oxide, can be achieved.

When the amount of the organic alkali used is too large, the property of removing the etching stopper layer containing aluminum oxide becomes high, and the side etching of the etching stopper layer containing aluminum oxide increases. On the other hand, when the amount of the organic alkali used is too small, the property of removing the photoresist film or the residue generated after the ashing treatment of photoresist, and the etching stopper layer containing aluminum oxide, becomes insufficient.

### [Organic solvent]

The organic solvent used in the present invention is not particularly limited (excluding dimethyl sulfoxide), as long as it is a solvent that can suppress the removal of the aluminum oxide as an etching stopper layer, while removing the photoresist film or the residue generated after the ashing treatment of photoresist. The present organic solvent is preferably one or more types selected from the group consisting of glycol ether, acetonitrile, and acetone.

Specifically, the glycol ethers are preferably one or more types selected from The group consisting of diethylene glycol monomethyl ether, diethylene glycol monobutyl ether, ethylene glycol monobutyl ether, and diethylene glycol monohexyl ether, with diethylene glycol monobutyl ether being particularly preferable.

These organic solvents may be used alone as one type or in combination of two or more types. These organic solvents can be easily obtained as commercially available products, and can be preferably used.

The concentration of the organic solvent is preferably 45% by mass to 85% by mass, more preferably 50% by mass to 80% by mass, and particularly preferably 55% by mass to 75% by mass, with respect to the total mass of the cleaning solution.

When the amount of the organic solvent used is too small, the property of removing the etching stopper layer containing aluminum oxide becomes high, and the side etching of the etching stopper layer containing aluminum oxide may increase in some cases. In addition, the anticorrosive property of a metal wiring may become insufficient. On the other hand, when the amount of the organic solvent used is too large, the property of removing the etching stopper layer containing aluminum oxide decreases, and the cleaning time may become long in some cases.

### [Water]

The cleaning solution of the present invention contains water, other than amines or quaternary ammonium hydroxide and an organic solvent.

The water used in the present invention is not particularly limited, and examples thereof may include tap water, industrial water, groundwater, distilled water, ion exchange water, and ultrapure water. Among these, ion exchange water is preferable, and ultrapure water is more preferable.

The content of water in the cleaning solution is preferably in the range of 10% to 70% by mass, and more preferably in the range of 15% to 60% by mass.

### [Cleaning solution]

The cleaning solution of the present invention can be prepared by uniformly stirring amines or quaternary ammonium hydroxide, an organic solvent, and water, using a conventional method. The cleaning solution of the present invention may contain other components other than the above-described components, such as, for example, an anticorrosive agent for metal wirings. Such an anticorrosive agent is not particularly limited, and azoles are preferable.

The pH of the cleaning solution is preferably pH 8 and 13, and more preferably pH 9 and 12. If the pH is too low, the property of removing the etching stopper layer containing aluminum oxide and the anticorrosive property of the metal wiring will decrease. If the pH is too high, the property of removing the etching stopper layer containing aluminum oxide becomes high, and the side etching of the etching stopper layer containing aluminum oxide may increase in some cases.

The pH may be adjusted solely by the content of amines or quaternary ammonium hydroxide. However, acid may also be added, as long as it does not impair the object of the present invention.

### [Semiconductor circuit element]

A semiconductor circuit element, for which the cleaning solution of the present invention is used, preferably has a metal wiring, an interlayer dielectric film, and an etching stopper layer, and preferably has a photoresist film or a photoresist residue after ashing on the interlayer dielectric film. Moreover, the interlayer dielectric film may contain a low-dielectric constant film (low-k film). Furthermore, the etching stopper layer preferably contains aluminum oxide.

### [Method for producing semiconductor circuit element]

The method for producing a semiconductor circuit element of the present invention comprises a step of removing a photoresist residue after ashing, using the above-described cleaning solution of the present invention.

For example, the cleaning solution of the present invention can be used by a method such as an immersion treatment or a single-wafer treatment, with respect to semiconductor circuit elements after etching treatment. The treatment temperature is usually 20°C to 80°C, and preferably 30°C to 65°C. The treatment time is usually 0.5 to 5 minutes, and preferably 1 to 3 minutes. After using the cleaning solution of the present invention, as a rinsing liquid, rinsing with water is often sufficient, but an organic solvent such as alcohol, or ammonia water, may also be used.

### Examples

Hereinafter, the present invention will be specifically described in the following examples. However, the present invention is not limited at all by these examples.

### [Examples 1 to 26 and Comparative Examples 1 to 4]

Cleaning solutions having compositions shown in the following Table 1 and Table 2 were prepared. It is to be noted that the balance is water. The concentration units in Tables 1 and 2 represent % by mass.

**[Table 1]**

| | Amines or quaternary ammonium hydroxide | | Organic solvent | | pH | Positive resist removal | Negative resist removal | AlOx removal |
|---|---|---|---|---|---|---|---|---|
| | Type | Conc. | Type | Conc. | | | | |
| Example 1 | 2-(Methylamino)ethanol | 0.3 | Diethylene glycol monobutyl ether | 50 | 9 to 10 | Good | Good | Good |
| Example 2 | 2-(Methylamino)ethanol | 20 | Diethylene glycol monobutyl ether | 50 | 11 to 12 | Good | Good | Good |
| Example 3 | 2-(Methylamino)ethanol | 0.9 | Diethylene glycol monobutyl ether | 70 | 10 to 11 | Good | Good | Good |
| Example 4 | 2-(Methylamino)ethanol | 15 | Diethylene glycol monobutyl ether | 70 | 11 to 12 | Good | Good | Good |
| Example 5 | 2-(Methylamino)ethanol | 5 | Diethylene glycol monobutyl ether | 80 | 9 to 10 | Good | Good | Good |
| Example 6 | N,N-Bis(3-aminopropyl)ethylenediamine | 0.3 | Diethylene glycol monobutyl ether | 60 | 9 to 10 | Good | Good | Good |
| Example 7 | N,N-Bis(3-aminopropyl)ethylenediamine | 1 | Diethylene glycol monobutyl ether | 70 | 9 to 10 | Good | Good | Good |
| Example 8 | 3,3-Diaminopropylamine | 0.3 | Diethylene glycol monobutyl ether | 60 | 9 to 10 | Good | Good | Good |
| Example 9 | 3,3-Diaminopropylamine | 1 | Diethylene glycol monobutyl ether | 70 | 9 to 10 | Good | Good | Good |
| Example 10 | Diethylenetriamine | 0.1 | Diethylene glycol monobutyl ether | 60 | 9 to 10 | Good | Good | Good |
| Example 11 | Diethylenetriamine | 1 | Diethylene glycol monobutyl ether | 70 | 9 to 10 | Good | Good | Good |
| Example 12 | 4-Amino-1-butanol | 0.1 | Diethylene glycol monobutyl ether | 60 | 9 to 10 | Good | Good | Good |
| Example 13 | 4-Amino-1-butanol | 1 | Diethylene glycol monobutyl ether | 70 | 9 to 10 | Good | Good | Good |
| Example 14 | 6-Amino-1-hexanol | 0.1 | Diethylene glycol monobutyl ether | 60 | 9 to 10 | Good | Good | Good |
| Example 15 | 6-Amino-1-hexanol | 1 | Diethylene glycol monobutyl ether | 70 | 9 to 10 | Good | Good | Good |
| Example 16 | Tetramethylammonium hydroxide | 0.11 | Diethylene glycol monobutyl ether | 70 | 10 to 11 | Good | Good | Good |
| Example 17 | Tetramethylammonium hydroxide | 0.13 | Diethylene glycol monobutyl ether | 80 | 10 to 11 | Good | Good | Good |
| Example 18 | Tetramethylammonium hydroxide | 0.1 | Diethylene glycol monobutyl ether | 70 | 10 to 11 | Good | Good | Good |
| Example 19 | Tetramethylammonium hydroxide | 0.2 | Diethylene glycol monobutyl ether | 80 | 11 to 12 | Good | Good | Good |
| Example 20 | Tetrapropylammonium hydroxide | 0.2 | Diethylene glycol monobutyl ether | 70 | 11 to 12 | Good | Good | Good |
| Example 21 | Tetrapropylammonium hydroxide | 0.3 | Diethylene glycol monobutyl ether | 80 | 12 to 13 | Good | Good | Good |
| Example 22 | Tetrabutylammonium hydroxide | 0.3 | Diethylene glycol monobutyl ether | 70 | 11 to 12 | Good | Good | Good |
| Example 23 | Tetrabutylammonium hydroxide | 0.4 | Diethylene glycol monobutyl ether | 80 | 11 to 12 | Good | Good | Good |
| Example 24 | 2-(Methylamino)ethanol | 2 | Ethylene glycol monobutyl ether | 65 | 9 to 10 | Good | Good | Good |
| Example 25 | 2-(Methylamino)ethanol | 2 | Acetonitrile | 65 | 9 to 10 | Good | Good | Good |
| Example 26 | 2-(Methylamino)ethanol | 2 | Acetone | 65 | 9 to 10 | Good | Good | Good |

**[Table 2]**

| | Amines or quaternary ammonium hydroxide | | Solvent | | Anticorrosive agent | | pH | Positive resist removal | Negative resist removal | AlOx removal |
|---|---|---|---|---|---|---|---|---|---|---|
| | Type | Conc. | Type | Conc. | Type | Conc. | | | | |
| Comp.Ex. 1 | 2-(Methylamino)ethanol | 2 | Dimethyl sulfoxide | 65 | Non | - | 10 to 11 | Poor | Poor | Good |
| Comp.Ex. 2 | Tetramethylammonium hydroxide | 4 | Dimethyl sulfoxide | 30 | Non | - | 13 to 14 | Poor | Poor | Excessive |
| | | | Acetonitrile | 5 | | | | | | |
| Comp.Ex. 3 | Tetramethylammonium hydroxide | 10 | Dipropylene glycol monomethyl ether | 59 | 5-Methyl-benzotriazole | 1 | 13 to 14 | Good | Good | Excessive |
| Comp.Ex. 4 | Tetramethylammonium hydroxide | 1 | Dimethyl sulfoxide | 50 | 5-Methyl-benzotriazole | 1 | 12 to 13 | Good | Good | Excessive |

As each blanket wafer, AlOx (PVD sputter deposition; film thickness: 3,000 Å), a positive resist (novolac-type resist; film thickness: 7,500 Å), and a negative resist (acrylic resist; film thickness: 7,500 Å) were each cut into a 1 cm square. These coupons were immersed in 10 g of each cleaning solution described above at 60°C, while stirring the solution with a stirrer. The immersion time was 2 minutes for AlOx and 9 seconds for each resist. After the immersion, the coupons were rinsed twice in approximately 100 g of ultrapure water (UPW) by moving them at room temperature for 10 seconds, and thereafter, the resulting coupons were dried by N₂ blowing.

### < Determination of AlOx-removing property >

The Al ion concentration in the cleaning solution in which the AlOx coupons were immersed was measured using an ICP-OES (Agilent 5110). The film thickness (Å) of the dissolved AlOx was calculated from the Al ion concentration, and was then divided by the 2-minute coupon treatment time to calculate the etching rate (Å/min). An etching rate in the range of 6 and 40 Å/min was determined to be "good," while an etching rate greater than 40 Å/min was determined to be "excessive." The results are shown in Table 1 and Table 2.

### < Determination of resist-removing property >

The coupons were visually confirmed after they had been treated for 9 seconds. If 95% or more of the base was visible in the coupon area, the removing property was determined to be "good." If 95% or more of the base was not visible in the coupon area, the removing property was determined to be "poor." The results are shown in Table 1 and Table 2.

### < Measurement of pH of cleaning solution >

A FiveEasy pH meter FE20 manufactured by METTLER TOLEDO was used as a pH meter, and LE409 manufactured by the same company as described above was used as a pH electrode. After calibration had been carried out using standard samples of pH 7 and pH 10, the pH of each cleaning solution was measured. The results are shown in Tables 1 and 2.

### Reference Signs List

10: Metal wiring
20A: Photoresist film
20B: Photoresist residue after ashing
30: AlOx etching stopper layer
40: Interlayer dielectric film

## Claims

1. A cleaning solution that simultaneously removes a photoresist film or a residue generated after an ashing treatment of photoresist, and aluminum oxide as an etching stopper layer, in a step of forming a metal wiring on a substrate,
wherein the cleaning solution comprises at least one type of organic alkali selected from the group consisting of amines or quaternary ammonium hydroxide, and at least one type of organic solvent (excluding dimethyl sulfoxide), and
a concentration of the amines is 0.1% by mass to 25% by mass with respect to a total mass of the cleaning solution, or a concentration of the quaternary ammonium hydroxide is 0.05% by mass to 0.5% by mass with respect to a total mass of the cleaning solution.

2. The cleaning solution according to claim 1, wherein the amines or the quaternary ammonium hydroxide is one or more types selected from the group consisting of 2-(methylamino)ethanol, 2-(ethylamino)ethanol, N,N-bis(3-aminopropyl)ethylenediamine, 3,3-diaminodipropylamine, ethylenediamine, diethylenetriamine, 4-amino-1-butanol, 6-amino-1-hexanol, tetramethylammonium hydroxide, tetraethylammonium hydroxide, tetrapropylammonium hydroxide, and tetrabutylammonium hydroxide.

3. The cleaning solution according to claim 1 or 2, wherein the organic solvent is one or more types selected from the group consisting of glycol ethers, acetonitrile, and acetone.

4. The cleaning solution according to claim 3, wherein the glycol ethers are one or more types selected from the group consisting of diethylene glycol monomethyl ether, diethylene glycol monobutyl ether, ethylene glycol monobutyl ether, and diethylene glycol monohexyl ether.

5. The cleaning solution according to any one of claims 1 to 4, wherein a concentration of the amines is 0.3% by mass to 10% by mass with respect to a total mass of the cleaning solution, or a concentration of the quaternary ammonium hydroxide is 0.1% by mass to 0.4% by mass with respect to a total mass of the cleaning solution.

6. The cleaning solution according to any one of claims 1 to 5, wherein a concentration of the organic solvent is 45% by mass to 85% by mass with respect to a total mass of the cleaning solution.

7. The cleaning solution according to any one of claims 1 to 6, wherein a pH of the cleaning solution is in a range of pH 8 to 13.

8. A method for producing a semiconductor circuit element, comprising a step of removing a photoresist or a photoresist residue after ashing, using the cleaning solution according to any one of claims 1 to 7.
